# EUROPÄISCHE PATENTSCHRIFT

(11) **EP 3 791 194 B1**
(45) Veröffentlichungstag und Bekanntmachung des Hinweises auf die Patenterteilung: **19.07.2023**
(21) Anmeldenummer: 19725045.9
(22) Anmeldetag: 07.05.2019
(51) Int. Cl.: G01R 31/12, G01R 31/62

(54) **AKKUSTISCHES ZUSTANDSÜBERWACHUNGSVERFAHREN UND -SYSTEM FÜR ELEKTRISCHE LEISTUNGSKOMPONENTEN, INSBESONDERE TRANSFORMATOREN**
ACOUSTIC CONDITION MONITORING METHOD AND SYSTEM FOR ELECTRICAL POWER COMPONENTS, IN PARTICULAR TRANSFORMERS
PROCÉDÉ ET SYSTÈME DE SURVEILLANCE ACOUSTIQUE DE L'ÉTAT POUR COMPOSANTS ÉLECTRIQUES DE PUISSANCE, EN PARTICULIER DES TRANSFORMATEURS

(30) Priorität: 07.05.2018 DE 102018003744
(43) Veröffentlichungstag der Anmeldung: 17.03.2021
(73) Patentinhaber: Siemens Gamesa Renewable Energy Service GmbH, 20097 Hamburg (DE)
(72) Erfinder: NAJAFI, Seyed Amir Mahmood, 73230 Kirchheim unter Teck (DE)
(74) Vertreter: Glawe, Delfs, Moll
(86) Internationale Anmeldenummer: PCT/EP2019/061695
(87) Internationale Veröffentlichungsnummer: WO 2019/215162

(56) Entgegenhaltungen:
- EP-A2- 1 439 396
- DE-T2- 60 025 927

## Beschreibung

Die Erfindung betrifft ein Zustandsüberwachungssystem sowie entsprechendes Verfahren für elektrische Leistungskomponenten, insbesondere einen Transformator, mit einer Detektoreinheit zur Erfassung von Teilentladungen und umfassend mindestens einen Sensor zur Erfassung akustischer Signale einer Teilentladung. Aus der DE60025927T2 ist ein System zum Überwachen der Funktionen einer elektrischen Einrichtung bekannt.

Elektrische Leistungskomponenten wie beispielsweise Transformatoren werden häufig unter rauen Einsatzbedingungen betrieben. Das gilt besonders bei modernen Windenergieanlagen, die häufig an unwirtlichen und abgelegenen Standorten aufgestellt und betrieben werden. Das gilt in besonderem Maße für auf See angeordneten Windenergieanlagen in sogenannten Offshore-Windparks. Bei diesen ist der Zugang für Wartung und Reparatur schwierig. Die Windenergieanlagen und ihre Komponenten, insbesondere ihre leistungsführenden Komponenten (Leistungskomponenten) sind daher auf lange Lebensdauer ausgelegt. Dennoch kann es aber vorkommen, dass Leistungskomponenten vorzeitig ausfallen. Insbesondere bei Transformatoren besteht das Problem, dass sie zwar generell langlebig sind, aber dennoch ein gewisser Teil der Transformatoren vorzeitig ausfällt. Da bei einem solchen Ausfall die Windenergieanlage nicht mehr weiterbetrieben werden kann, ist eine schnelle Reparatur erforderlich. Dies kann aufwendig sein, insbesondere bei abgelegenen Windenergieanlagen oder solchen auf See.

Eine bedeutende Ursache für vorzeitige Ausfälle von elektrischen Leistungskomponenten, insbesondere Transformatoren, sind sogenannte Teilentladungen. Kommt es hierbei zu einer schlagartigen Entladung im Isoliermaterial, sei es im Öl bei ölisolierten Leistungskomponenten oder in anderen, insbesondere festen, schlecht leitenden Materialien (Isolatormaterial, ggf. auch Halbleiter), spricht man von einer Teilentladung ("TE", oder "PD" für partial discharge). Eine Teilentladung für sich ist in der Regel unschädlich, jedoch kann jede zu einer gewissen lokalen Schädigung führen. Je nach Umfang und Anzahl der Teilentladungen führen sie über die Zeit hinweg zum Ausfall der elektrischen Leistungskomponente. Im Grunde kann man sagen, dass jede Teilentladung einen infinitesimalen Schritt bildet auf dem Weg zur Zerstörung der elektrischen Leistungskomponente, insbesondere eines Transformators. Teilentladungen an sich sind nur mit sehr hohem Aufwand durch eine aufwändige Auslegung vermeidbar. Da dem zumindest wirtschaftliche Erwägungen entgegenstehen, werden z. B. Öltrafos so ausgelegt, dass Teilentladungen bis zu 100 pC als unschädlich angesehen werden können. Es ist versucht worden, deren Auftreten zu erfassen und zur Grundlage eines Monitoring für die Leistungskomponente zu machen. Teilentladungen sind im Grunde an den durch die Entladung hervorgerufenen elektrischen Strömen und ihren elektromagnetischen Feldern zu erkennen. Die Teilentladungen sind auch häufig begleitet von entsprechenden akustischen Phänomenen, wie knallartigen Geräuschen. Diese können je nach Größe der Teilentladung mehr oder weniger laut ausfallen. Jedoch sind sie nicht immer hörbar; es gibt auch sogenannte stumme, also akustisch nicht erfassbare, Teilentladungen, die dann nur über ihre elektrischen und elektromagnetischen Wirkungen erfassbar sind. Dazu zählen auch sehr leise Teilentladungen.

Basierend darauf ist versucht worden, Sensoren für elektrische Felder vorzusehen, um so Signale von Teilentladungen zu detektieren. Gerade an elektrischen Leistungskomponenten mit hohen elektromagnetischen Feldstärken (insbesondere Transformatoren) hat sich dies jedoch mitunter als schwierig erwiesen. Starke Veränderungen der elektromagnetischen Felder können auch einfach auf dem Betrieb der Komponente beruhen, und können auch ohne Teilentladungen auftreten. Eine zuverlässige Erkennung der im Verhältnis schwächeren Signale der Teilentladungen konnte so nicht erreicht werden.

Es sind auch Verfahren mit elektrischen und akustischen Sensoren versucht worden. Beispielsweise ist aus der WO 01/18554 A1 ein Monitoringsystem zur Überwachung auf Teilentladungen bekannt. An der überwachten Leistungskomponente ist ein Ultraschallwandler zur Erfassung von akustischen Signalen vorgesehen und ferner sind Sensoren zur Erkennung von elektrischen, insbesondere elektromagnetischen Signalen vorgesehen. Treten Teilentladungen auf, so erkennen die Sensoren entsprechende hochfrequente elektrische Felder. Zur Verifizierung, dass es sich bei den detektierten elektrischen Feldern auch um solche aufgrund einer Teilentladung handelt, ist zusätzlich eine Auswertung der Signale des akustischen Sensors vorgesehen. Nur dann, wenn innerhalb einer kurzen vorbestimmten Zeitspanne nach dem Auftreten eines elektromagnetischen Signals ein entsprechendes akustisches Signal folgt, wird der gemessene Vorgang als Teilentladung gewertet. Auf diese Weise fungiert die Akustik als Filter zur Verbesserung der Signalqualität. Problematisch an diesem Konzept ist, dass es gewisse Teilentladungen gibt, die keine oder nur eine sehr leise akustische Signatur aufweisen; diese werden dann häufig nicht als Teilentladung erkannt sondern durch die Filterung unterdrückt. Die durch die Verwendung beider Sensordaten, akustischer und elektromagnetischer, erhoffte Qualitätsverbesserung wird dadurch zumindest teilweise zunichte gemacht.

Der Erfindung liegt die Aufgabe zugrunde, mit möglichst einfachen Mitteln eine zuverlässige Überwachung zu erreichen.

Die erfindungsgemäße Lösung liegt in einem Verfahren bzw. Zustandsüberwachungssystem mit den Merkmalen der unabhängigen Ansprüche. Vorteilhafte Weiterbildungen sind Gegenstand der abhängigen Ansprüche.

Bei einem Zustandsüberwachungssystem für elektrische Leistungskomponenten, insbesondere einen Transformator, umfassend eine Teilentladungs-Detektoreinheit, die ausgebildet ist zur Erfassung von Teilentladungen, mit mindestens einem A-Sensor zur Erfassung akustischer Signale; und eine Verarbeitungseinheit zur Verarbeitung der von dem A-Sensor detektierten Signale ist erfindungsgemäß vorgesehen, dass die Verarbeitungseinheit eine Häufigkeits-Bestimmungseinrichtung, welche eine Häufigkeit der von dem A-Sensor detektierten Teilentladungen erfasst und ein Häufigkeitssignal ausgibt, sowie ein Histogramm-Modul umfasst, das dazu ausgebildet ist, aus dem Häufigkeitssignal und einem Zeitsignal einen Zeitverlauf der Häufigkeit zu bestimmen, und eine Analyseeinheit vorgesehen ist, die dazu ausgebildet ist, den Zeitverlauf auf Ab- und/oder Anstieg zu überwachen und bei Überschreitung einer einstellbaren Schwelle ein Warnsignal auszulösen.

Generell kommt es insbesondere aufgrund der durch Teilentladungen hervorgerufenen thermischen Wirkungen zu einer meist schleichenden Verschlechterung des Zustands von Materialien der elektrischen Leistungskomponente. Bei Transformatoren handelt es sich hierbei insbesondere um Isolatormaterial. Darunter fallen flüssige oder feste Stoffe, wie beispielsweise Öl oder Isolierpapier. Dies sei am Beispiel des Isolierpapiers erläutert: Wegen der thermischen Wirkung kommt es zu Karbonisierungen im Isolierpapier, wodurch dessen elektrische Isolationsfähigkeit herabgesetzt wird. Im Grunde gilt, je stärker die Teilentladung und somit je stärker die Karbonisierung, desto stärker auch die akustische Signatur.

Unter der Häufigkeit wird ein allgemeines Maß dafür verstanden, wie oft ein Ereignis (wie die Teilentladung) auftritt. Das Auftreten des Ereignisses an sich ("Incidence") ist, worauf sich die Häufigkeit ("Incidence Rate") bezieht; es ist zu unterscheiden von einer Frequenz eines akustischen Signals ("Tonhöhe").

Die Erfindung ermöglicht eine verbesserte Bestimmung des Schädigungsgrads basierend auf akustischer Detektion der Teilentladungen. Dies beruht auf der Erkenntnis, dass es auf die nur schwer realisierbare Erfassung von stummen Teilentladungen gar nicht ankommt, weil diese für Schädigungen und insbesondere Karbonisierungen im Feststoff nicht relevant sind. Deshalb reicht es grundsätzlich aus, wenn bei der Auswertung der akustisch erfassten Teilentladungen auf gewisse Veränderungen der Häufigkeit abgestellt wird. Die Erfindung macht sich hierbei zu Nutze, dass insbesondere Kombinationen von Ab- und Anstiegen eine gute Bestimmung von Schädigungen durch Teilentladungen ermöglichen, und zwar unabhängig von der Gesamtzahl der Teilentladungen. Speziell macht sich die vorliegende Erfindung die Erkenntnis zu Nutze, dass das allererste akustische Signal der allerersten non-silent Teilentladung (TE) im Feststoff die höchste akustische Amplitude überhaupt hat. Danach sinken sowohl die Amplituden der akustischen Signale wie auch die Häufigkeit der Teilentladungen wegen der nun begonnenen und weiter fortschreitenden Karbonisierung. Dies kann detektiert werden. Die Erfindung hat weiter erkannt, dass, sobald auf diesen Abstieg der Häufigkeit (nach in der Regel längerer Zeit mit niedriger Häufigkeit) eine deutliche Steigerung der Häufigkeit folgt, dies ein klares Indiz für einen bevorstehenden schwereren Schaden und drohenden Ausfall der Komponente ist. Die Erfindung macht sich dies zunutze, indem sie die Häufigkeitsrate auf eine solche Kombination aus Ab- und Anstieg überwacht.

Damit ermöglicht es die Erfindung, den wahrscheinlichen Ausfall einer elektrischen Leistungskomponente rechtzeitig zu erkennen und entsprechend zu warnen und gegebenenfalls die Komponente auch abzuschalten, sei es automatisch oder nach entsprechender Prüfung und Freigabe. Dass dies ohne Berücksichtigung der nur schwer oder nicht zu erfassenden stummen Teilentladungen gelingt, ist im einschlägigen Stand der Technik ohne Beispiel.

Zweckmäßigerweise weist die Analyseeinheit ein Mustererkennungsmodul auf, das mindestens ein Referenzmuster umfasst und dazu ausgebildet ist, eine Übereinstimmung des Zeitverlaufs mit dem Referenzmuster zu bewerten. Auf diese Weise kann eine Heuristik erreicht werden, um so die Erkennungsgenauigkeit zu verbessern. Besonders bewährt hat sich die Vorgabe bestimmter Muster für Ab- und Anstiege als Referenzmuster. Das Mustererkennungsmodul prüft, ob der Zeitverlauf der Häufigkeitssignale mit dem Referenzmuster übereinstimmt. Mit Vorteil ist hierbei das Referenzmuster mehrphasig ausgeführt. Bewährt hat sich eine Aufteilung in Anfangsphase, Hauptphase und Endphase. Die Anfangsphase umfasst hierbei häufig die Inbetriebnahme und das sich anschließende "Einbrennen", also eine Phase mit vergleichsweise hoher Häufigkeit von Teilentladungen in der elektrischen Leistungskomponente, die Hauptphase umfasst den sich daran anschließenden Regelbetrieb (bei dem Teilentladungen meist nur mit geringer Häufigkeit auftreten), und die Endphase zeichnet sich aus durch einen deutlichen Anstieg der Häufigkeit der Teilentladungen. Eine verlässliche Erkennung der Hauptphase setzt dabei die Kenntnis der Teilentladungen in der Anfangsphase voraus.

Besonders zweckmäßig ist eine automatische Parametrisierung des Referenzmusters. Diese umfasst vorzugsweise eine automatische Verstärkungsregelung. Auf diese Weise kann eine Anpassung an das Absolutniveau der gemessenen Häufigkeiten automatisch erfolgen. So kann eine einfache Anpassung an unterschiedliche elektrische Leistungskomponenten erfolgen, und zwar abhängig davon, ob sie ein generell eher höheres Niveau von Teilentladungen aufweisen oder ein eher niedrigeres Niveau. Durch eine solche automatische Verstärkungsregelung kann eine optimale Anpassung erreicht werden. Fehlparametrisierungen können damit verhindert werden, so dass die Erkennungsgenauigkeit im Ergebnis steigt.

Die von akustischen Sensoren aufgezeichneten Signale können beeinträchtigt sein durch Umgebungsgeräusche. Um deren Einfluss zu verringern, ist mit Vorteil eine Adaption vorgesehen. Sie ist dazu ausgebildet, eine Kalibrierung der Analyseeinheit auf Umgebungsgeräusche vorzunehmen. Auf diese Weise kann der Einfluss der Umgebungsgeräusche herausgerechnet werden. In der einfachsten Art kann dies durch einen Minimumdetektor realisiert sein, der das Grundrauschen ("noise floor") erfasst und die Verarbeitung der gemessenen Signale entsprechend kompensiert.

Zweckmäßig ist es, wenn die Analyseeinheit weiter dazu ausgebildet ist, eine Anstiegssteilheit der Häufigkeit zu berechnen und abhängig davon das Warnsignal auszulösen. Es hat sich gezeigt, dass gerade die Steilheit ein gut geeignetes Maß ist, um eine deutliche Verschlechterung der elektrischen Komponente frühzeitig zu erkennen. Als Schwelle für das Auslösen eines Warnsignals genügt im Grunde ein statischer Schwellwert. Zusätzlich oder alternativ kann aber auch vorgesehen sein, dass ein dynamischer Schwellwert umfasst ist. Dieser kann variiert werden, beispielsweise abhängig von nebengeordneten Faktoren, wie der Höhe des Grundrauschens oder der Störungen durch Neben- und Umgebungsgeräusche, oder aber auch historischen Faktoren, wie beispielsweise, wie lange eine Phase des Referenzmusters bereits andauert.

Mit Vorteil ist eine Einschaltsperre vorgesehen, die mit der Verarbeitungseinheit und/oder der Analyseeinheit derart zusammenwirkt, dass nach einem Abschalten beim anschließenden Wiedereinschalten das Überwachen der Teilentladungen gesperrt ist. Beispielsweise kann dies durch Überwachen der Klemmenspannung des Transformators erfolgen. Damit wird vermieden, dass beim Abschalten und insbesondere beim anschließenden Wiedereinschalten unvermeidlich auftretende Entladungen bzw. Teilentladungen die Auswertung verfälschen. Ansonsten besteht das Risiko, dass durch die beim Ab-/Wiederanschalten bewirkte Erhöhung der Häufigkeit der Teilentladungen fälschlicherweise auf einen bevorstehenden Defekt geschlossen wird. Durch die Einschaltsperre ist dies wirkungsvoll verhindert.

Vorzugsweise weist die Analyseeinheit ferner einen Burstdetektor für die detektierten Teilentladungen auf, der dazu ausgebildet ist, bei Überschreiten eines Schwellwerts das Warnsignal auszulösen. Damit kann gezielt darauf reagiert werden, wenn plötzlich eine ganze Salve von Teilentladungen akustisch detektiert wird. Auch dies kann ein bedeutendes Zeichen für einen bevorstehenden Ausfall der elektrischen Leistungskomponente sein. Hierbei können Grenzen für Anzahl der Teilentladungen und Dauer der Salven voreingestellt sein.

Gemäß einer besonders vorteilhaften Ausgestaltung der Erfindung, die ggf. unabhängigen Schutz verdient, ist ferner vorgesehen, dass bei der Verarbeitung eine Lokalisation der akustischen Signale erfolgt. Dazu kann die Verarbeitungseinheit mit einer Lokalisator-Einheit versehen sein. Sie ist dazu ausgebildet, aus den Signalen des akustischen Sensors eine Ortsinformation über den Ort der aufgetretenen Teilentladung zu bestimmen. Vorzugsweise sind dazu räumlich verteilt mehrere Akustiksensoren an der Leistungskomponente vorgesehen. Bei der Auswertung werden dann die Signale dieser mehreren Akustiksensoren miteinander, und zwar zweckmäßigerweise phasensensitiv, verknüpft. Es kann dann durch Laufzeit- bzw. Phasendifferenzen zwischen den Akustiksensoren zusätzlich die Richtung und somit im Ergebnis der genaue Ort der Teilentladung ermittelt werden. Optional kann dazu vorgesehen sein, dass die akustischen Sensoren phasensensitiv und/oder als Stereo-Aufnehmer ausgeführt sind.

Die Lokalisation kann ferner eine Erkennung des Ortes einer Teilentladung umfassen. Die Erfindung hat erkannt, dass die Teilentladungen generell als ortsfest anzusehen sind; wird ein anderer Ort ermittelt, dann sind solche Teilentladungen an anderen Positionen immer als zusätzliche Schadensquelle anzusehen. Die Lokalisierung bietet damit die Möglichkeit, Teilentladungen in Öl von denen in Feststoff zu unterscheiden. Eine weitere Möglichkeit ergibt sich aus den akustischen Signaturen der Teilentladungen. Solche in Öl sind praktisch konstant, sowohl in der Häufigkeit als auch in der Lautstärke. Das ist auf die Menge des Öls und dessen Zirkulation zurückzuführen, in Verbindung damit, dass die Teilentladungen ortstreu sind. Da das Öl ständig zirkuliert, ist am Ort der Teilentladung stets frisches Öl, so dass die Teilentladungen immer gleich sind. Sie bilden damit eine Art Grundrauschen. Davon kann man die sich in Häufigkeit und Lautstärke verändernden Teilentladungen im Feststoff gut unterscheiden.

Es ist zweckmäßig, ferner eine Schadenbestimmungseinheit vorzusehen, die zur Bestimmung eines Indikators für einen Schädigungsgrad der Leistungskomponente ausgebildet ist. Damit kann ein Maß für die durch das Auftreten der Teilentladungen bewirkte Schädigung gebildet werden. Ferner kann darauf basierend und vorzugsweise unter Einbeziehung eines Langzeitspeichers ein Maß für eine erwartete Restlebensdauer bestimmt werden. Dies ermöglicht es, anhand von solchen Indikatoren zu entscheiden, ob die Leistungskomponente bei der nächsten Wartung zu berücksichtigen ist oder ob sie noch längere Zeit sicher betrieben werden kann, beispielsweise bis zum übernächsten Wartungstermin oder darüber hinaus. So kann zum einen die Gefahr eines unerwarteten Ausfalls verringert werden, wodurch die Zuverlässigkeit der Leistungskomponente steigt, und andererseits kann unnötiger Wartungsaufwand vermieden werden. Die Erfindung hat ferner erkannt, dass es ein besonders bedeutender Indikator für den Schädigungsgrad ist, wenn mehrere Teilentladungen am selben Ort in Feststoff-Materialien stattfinden. Ist dies der Fall, so werden in Zusammenwirkung mit der Lokalisator-Einheit solche Teilentladungen bei der Bestimmung des Schädigungsindikators höher gewichtet. Auf diese Weise kann die Prognosesicherheit deutlich gesteigert werden.

Ferner ist zweckmäßigerweise eine Schnittstelle vorgesehen, über die das Warnsignal zu einem (meist entfernt sitzenden) Betreiber übermittelt wird. Damit kann aus der Ferne darüber entschieden werden, ob die Leistungskomponente noch hinreichend betriebssicher ist, oder ob sie demnächst im Rahmen einer Wartung und/oder Reparatur wieder in Stand gesetzt oder ausgetauscht werden muss.

Grundsätzlich sind für die Erfindung ausschließlich akustische Sensoren vorgesehen. Es soll aber bei einer Variante, die gegebenenfalls auch unabhängigen Schutz verdient, nicht ausgeschlossen sein, dass optional zusätzlich auch elektromagnetische Sensoren vorgesehen sind. Zur Verarbeitung von deren Signalen zusammen mit den akustischen Signalen kann ein Korrelationsmodul vorgesehen sein. Es kann so die Erkennungssicherheit noch weiter gesteigert werden. Zudem kann die Lokalisierung verbessert werden.

Die Erfindung bezieht sich ferner auf ein entsprechendes Zustandsüberwachungsverfahren. Zur näheren Erläuterung wird auf vorstehende Beschreibung verwiesen.

Die Erfindung wird nachfolgend anhand einer vorteilhaften Ausführungsform beispielhaft erläutert. Es zeigen:
Fig. 1 eine schematische Ansicht einer erfindungsgemäßen Zustandsüberwachung an einer Windenergieanlage mit einem Anlagentransformator;
Fig. 2 eine Schemaansicht zu einem Transformator mit erfindungsgemäßem Zustandsüberwachungssystem; und
Fig. 3a-c Diagramme zu einem Referenzmuster und Messwerten mit Schwellwerten der Zustandsüberwachung.

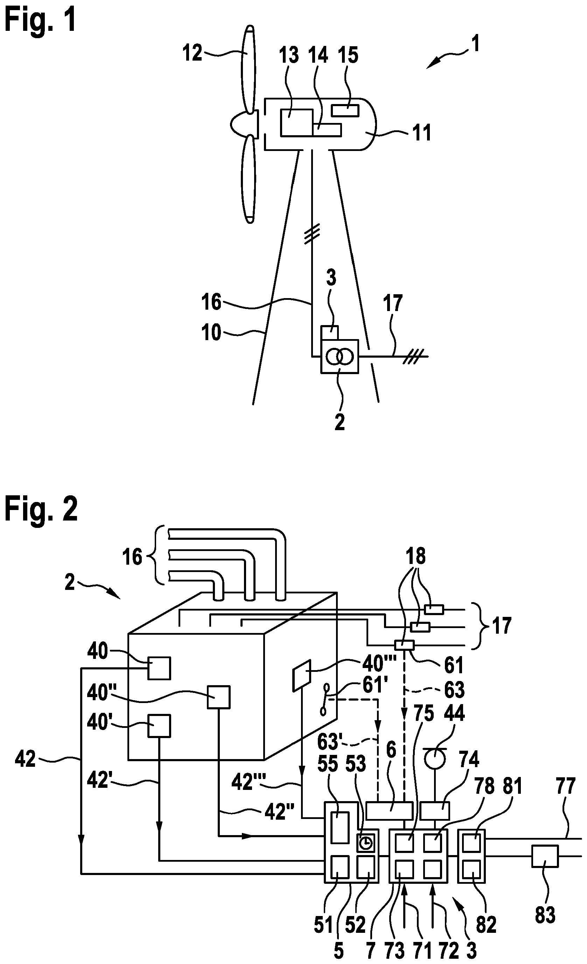

Die Erfindung wird erläutert am Beispiel eines Transformators (sog. Anlagentransformator) im Leistungsstrang einer Windenergieanlage. Es versteht sich, dass auch Transformatoren anderer Anlagen und natürlich auch Transformatoren zum Anschließen von Windparks an ein Netz entsprechend überwacht werden können. Eine in ihrer Gesamtheit mit der Bezugsziffer 1 bezeichnete Windenergieanlage mit einer gemäß der Erfindung ausgeführten Zustandsüberwachung ist in Figur 1 dargestellt.

Die Windenergieanlage 1 ist an sich konventionell ausgeführt mit einem Turm 10, an dessen oberem Ende eine Gondel 11 in Azimutrichtung verschwenkbar befestigt ist. An einer Stirnseite der Gondel 11 ist ein Windrotor 12 drehbar angeordnet, der über eine (nicht dargestellte) Rotorwelle einen Generator 13 antreibt. Der Generator 13 wirkt mit einem Umrichter 14 zusammen, um die mechanische Leistung des Windrotors 12 in elektrische Leistung umzuwandeln. Der Betrieb der Windenergieanlage 1 wird kontrolliert von einer Betriebssteuerung 15, mit der die Komponenten der Windenergieanlage mittels nicht dargestellter Signalleitungen verbunden sind.

Die erzeugte elektrische Leistung wird über eine Steigleitung 16 durch den Turm geführt bis zu einem im Ausführungsbeispiel am Fuß des Turms 10 angeordneten Anlagentransformator 2 der Windenergieanlage 1. Dieser ist dazu ausgebildet, die auf Niederspannungsniveau (ca. 1000 V) vom Generator 13 bzw. Umrichter 14 abgegebene elektrische Leistung bezüglich ihrer Spannung auf Mittelspannungsniveau hochzusetzen und über eine Anschlussleitung 17 abzugeben, beispielsweise an ein windparkinternes Netz (nicht dargestellt).

Für den Anlagentransformator 2 ist ein Zustandsüberwachungssystem 3 gemäß einem Ausführungsbeispiel der Erfindung vorgesehen. Es ist dazu ausgebildet, das erfindungsgemäße Verfahren auszuführen.

An eine Primärseite des Transformators 2 ist die Niederspannung führende Steigleitung 16 angeschlossen. An eine Sekundärseite des Transformators 2 angeschlossen ist die auf Mittelspannungsniveau betriebene Anschlussleitung 17.

Es wird nun Bezug genommen auf Fig. 2. An dem Transformator angeordnet sind akustische Sensoren (A-Sensoren). Sie sind als Ultraschallsensoren ausgeführt. Der A-Sensor 40 ist an dem Transformator 2 in einer zur Schallübertragung geeigneten Weise an einer vorbestimmten Stelle angeordnet, vorzugsweise an einer solchen Stelle mit guter akustischer Ankopplung an ein Feststoffmaterial, insbesondere Ölpapier, umfassendes Isolatormedium des Transformators 2. Dieser A-Sensor 40 ist dazu ausgebildet, akustisch detektierbare Teilentladungen in dem Feststoff-Isolatormedium und im Öl zu erfassen und entsprechende Signale über eine Signalleitung 42 an eine Verarbeitungseinheit 5 des Zustandsüberwachungssystems 3 auszugeben.

Weiter sind optional zusätzliche akustische Sensoren (A-Sensoren) 40', 40", 40"' vorgesehen. Hierbei seien drei der A-Sensoren 40, 40' und 40" in einer Dreiergruppe angeordnet, und zwar in Form eines gleichseitigen Dreiecks. Ferner ist ein Sensor 40"' etwas abgesetzt angeordnet; dieser kann optional als ein Stereo-Aufnehmer ausgeführt sein. Die A-Sensoren 40', 40" und 40"' sind über weitere Signalleitungen 42', 42", 42"' mit der Verarbeitungseinheit 5 verbunden.

Die Verarbeitungseinheit 5 weist als Eingangsstufen eine Häufigkeit-Bestimmungseinrichtung 51 auf, an welche die Signale der A-Sensoren 40, 40', 40" und 40"' angeschlossen sind.

Die Verarbeitungseinheit 5 weist ferner ein Histogramm-Modul 52 auf, das dazu ausgebildet ist, aus dem von der Häufigkeit-Bestimmungseinrichtung 51 ermittelten Häufigkeitssignal und einem von einem Zeitgeber 53 gesteuerten Zeitsignal einen Zeitverlauf der Häufigkeit zu bestimmen. Auf diese Weise kann ermittelt werden, wie oft das von den akustischen Sensoren 40 erfasste Ereignis "Teilentladung" im Lauf der Zeit auftritt. Es können so Veränderungen der Häufigkeit bestimmt werden, insbesondere, inwieweit die Häufigkeit ansteigt oder abfällt bzw. auf einem eher konstanten (sei es hohem oder niedrigem) Niveau verharrt. Diese Analyse der Häufigkeit und ihrer Veränderungen erfolgt mittels einer Analyseeinheit 7, die mit der Verarbeitungseinheit 5 zusammenwirkt. Die Analyseeinheit 7 weist außerdem noch weitere Eingänge auf, nämlich solche für Signale für Schwellenwerte, insbesondere statische oder dynamische Schwellenwerte 71, 72. Die Analyseeinheit ist dazu ausgebildet, den von dem Histogramm-Modul 52 bestimmten Zeitverlauf auszuwerten, insbesondere auf Abstieg und/oder Anstieg zu überwachen, und bei Überschreiten der Schwellenwerte ein Warnsignal auszugeben. Für die Ausgabe des Warnsignals ist eine Warnleitung 77 vorgesehen.

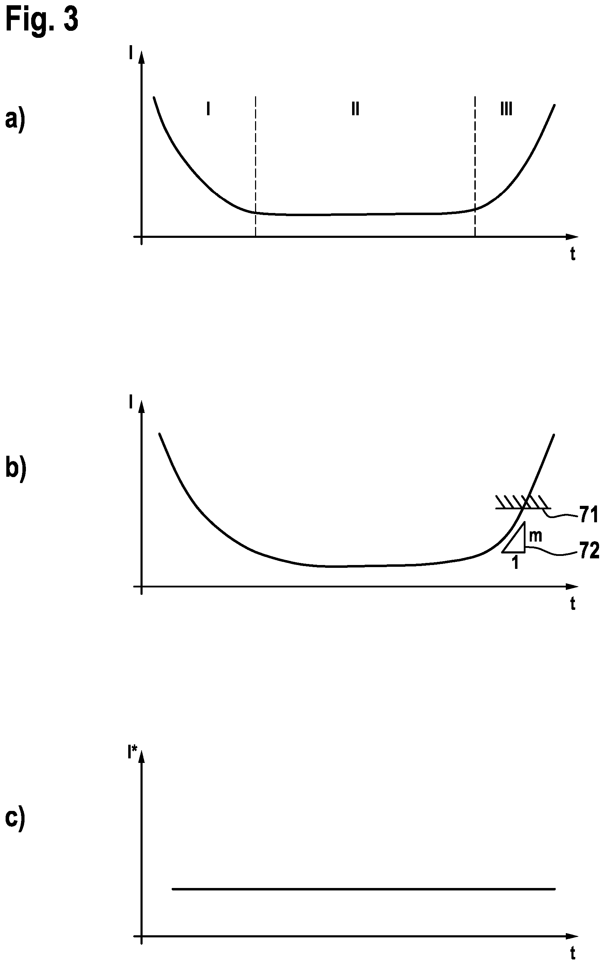

Die Analyseeinheit 7 weist ein Mustererkennungsmodul 73 auf, das einen Muster-Speicher (nicht dargestellt) aufweist. In dem Muster-Speicher können ein oder mehrere Referenzmuster gespeichert sein. Die Analyseeinheit 7 prüft mittels des Mustererkennungsmoduls 73, ob der bestimmte Zeitverlauf der Häufigkeit mit einem Referenzmuster übereinstimmt, und gibt dementsprechend Signale aus. Ein Beispiel für ein solches Referenzmuster ist in Figur 3a) dargestellt. Es zeigt einen typischen Verlauf der Häufigkeit I ("Incidence rate") von akustisch detektierbaren Teilentladungen im Feststoffmaterial (im vorliegenden Beispiel also einer Ölpapier-Isolierung) über die Zeit t bei einem Transformator als elektrische Leistungskomponente. Man erkennt drei Phasen I, II und III, wobei die Phase I für eine Anfangs- bzw. "Einbrenn"-Phase steht und die Inbetriebnahme an sich sowie die ersten Betriebsstunden bis -tage umfasst. Typisch für diese erste Phase ist, dass am Anfang Teilentladungen recht häufig auftreten. Dies ist charakteristisch. So treten ganz am Anfang sowohl sehr laute wie auch häufige Teilentladungen auf. Es wird davon ausgegangen, dass die erste Teilentladung im Grunde die lauteste ist, und die danach folgenden Teilentladungen tendenziell immer leiser und weniger häufig werden. Somit bietet Phase I eine gute Möglichkeit, insbesondere durch einen Vergleich der Häufigkeiten von Teilentladungen, Phase II verlässlich zu erkennen.

Phase II zeigt die sich daran anschließende Phase des stabilen Dauerbetriebs. Hierbei treten Teilentladungen seltener auf bzw. sind schwächer, sodass sie akustisch nicht immer zuverlässig detektiert werden können. Im Ergebnis ergibt sich somit eine niedrigere Häufigkeit der detektierten Teilentladungen über eine längere Zeit hinweg (sog. niedriges Plateauniveau). Dies ist der an sich erstrebenswerte sichere und zuverlässige Zustand für einen Dauerbetrieb. Zum Ende der Lebensdauer hin beginnt die Phase III. Hier steigt die Häufigkeit der Teilentladungen deutlich an und kann recht schnell hohe Werte erreichen. Wenn dieser Anstieg erkannt wird, bedeutet dies das Auftreten einer Schädigung des Transformators, und er sollte im Interesse der Zuverlässigkeit bald repariert oder ausgetauscht werden. Dies kann dann erfolgen, wenn ein statischer Schwellenwert 71 überschritten wird (beispielsweise mehr als 100 Teilentladungen über einen Zeitraum von fünf Minuten an einer Position), oder wenn die Anstiegssteilheit zu groß wird und so ein dynamischer Schwellenwert 72 überschritten wird (beispielsweise wenn sich in einem Messintervall von einigen Minuten/Stunden die Häufigkeit mehr als verdoppelt hat). Es versteht sich, dass sowohl die Höhe der Schwelle und/oder der Zeitraum, über den die Erfassung läuft, variiert werden kann . Der Erfassungszeitraum ist also vorteilhafterweise ebenfalls variabel. Je nach Art und Typ der elektrischen Komponente kann es einen Unterschied machen, ob der Schwellenwert bei 20 Teilentladungen in einer Minute oder bei 100 Teilentladungen in 5 Minuten gelegt wird.

Das vorstehend beschriebene Beispiel eines Referenzmusters entspricht somit einem "Badewannen"-Verlauf. Es können aber auch weitere, andere Referenzmuster in dem Muster-Speicher eingespeichert sein.

In Fig. 3b) ist ein Beispiel für einen gemessenen Zeitverlauf der Häufigkeit dargestellt. Man erkennt die Anfangsphase mit dem charakteristischen Abfall der Häufigkeit der Teilentladungen und die sich über einen langen Zeitraum erstreckende Plateauphase mit nur wenigen akustisch erfassten Teilentladungen. Zum Ende hin steigt die Häufigkeit deutlich an, um bedingt durch die hohe Anstiegssteilheit zuerst eine dynamische Schwelle 72 und kurz darauf durch die stark angestiegene Häufigkeit auch die statische Schwelle 71 zu überschreiten. Das Warnsignal 77 wird ausgelöst.

Das Referenzmuster bildet lediglich ein schematisches Muster. Es ist in der Regel nicht absolut skaliert. Seine Skalierung muss an den jeweiligen Anwendungsfall angepasst werden. Dies geschieht im Rahmen einer Kalibrierung. Die initiale Kalibrierung kann insbesondere durch die Häufigkeit der anfänglich auftretenden Teilentladungen am Beginn der Phase I erfolgen. Deren Häufigkeit wird erfasst und mittels eines geeigneten Kalibrierungsfaktors abgebildet auf den entsprechenden Absolutwert am Anfang der Phase I gemäß des Referenzmusters. Der entsprechende Kalibrierungsfaktor wird zweckmäßigerweise durch eine automatische Verstärkungsregelung 75 bestimmt, so dass letztlich durch diese Verstärkungsregelung eine automatische Anpassung erzielt wird. Dies bietet sich insbesondere auch für den Plateaubereich gemäß Phase II an. Durch die automatische Verstärkungsregelung wird ein Multiplikationswert bestimmt, der den tatsächlich gemessenen Wert für die Häufigkeit während dieser Phase II skaliert auf den entsprechenden Wert des Referenzmusters. Auf diese Weise können mit einem Referenzmuster unterschiedliche Anwendungsfälle, beispielsweise bei unterschiedlich großen Leistungskomponenten (oder verschiedenen Arten von Leistungskomponenten) abgedeckt werden. Die so bestimmte Kalibrierung erstreckt sich vorzugsweise auch auf den Endbereich in Phase III.

Zur besseren Anpassung an verschiedene Arten von Leistungskomponenten ist vorzugsweise vorgesehen, dass in dem Speicher unterschiedliche Referenzmuster abgelegt sind, von denen jedes auf einen bestimmten Typ von Leistungskomponenten ausgerichtet ist.

In Fig. 3c ist eine akustische Signatur der Häufigkeit I* von Teilentladungen in Öl dargestellt. Man erkennt, dass deren Signatur über die Zeit hinweg konstant bleibt. Dies findet seinen Grund darin, dass die Teilentladungen im Öl zwar typischerweise an derselben Stelle auftreten, jedoch wegen der Öl-Zirkulation stets frisches Öl an dieser Stelle zur Verfügung steht, sodass sich keine Veränderung der Häufigkeit der Teilentladung aufgrund von Karbonisierungseffekten ergibt. Im Grunde stellt die Häufigkeit dieser Teilentladung die Grundlinie für die akustische Auswertung dar, wie sie insbesondere für die Phase II beherrschend ist.

Um den Ort der Teilentladungen besser bestimmen zu können, ist optional vorgesehen, dass die Verarbeitungseinheit 5 eine Lokalisator-Einheit 55 umfasst. An diese sind die Signale von mehreren der A-Sensoren 40, 40', 40", 40"` angelegt. Sie ist dazu ausgebildet, eine Ortsinformation über den Ort der Teilentladung aus den Signalen der mehreren A-Sensoren zu bestimmen, beispielsweise durch Bestimmung von Laufzeitdifferenzen bzw. Triangulation. Auf diese Weise kann zusätzlich der Ort der jeweiligen Teilentladungen berücksichtigt werden. Dies ermöglicht eine deutlich verbesserte Bestimmung der Auswirkung der Teilentladungen, da mehrere an derselben Stelle auftretende Teilentladungen ein deutlicher Hinweis auf eine Schädigung der elektrischen Leistungskomponente sind und in der Regel einen beschleunigten Ausfall zur Folge haben. Ferner können so Ortsabweichungen der Teilentladungen erkannt werden, die ebenfalls ein Indiz für bevorstehenden Ausfall sein können.

Ferner ist optional eine Einschaltsperre 78 vorgesehen. Sie überwacht ein Abschalten bzw. Wiedereinschalten des Transformators 2, beispielsweise durch Überwachung von dessen Klemmenspannung mittels eines Spannungssensors (nicht dargestellt). Beim Erkennen der Schaltvorgänge wird die Auswertung durch Verarbeitungseinheit 5 bzw. Analyseeinheit 7 gesperrt. Damit kann vermieden werden, dass die Auswertung aufgrund von Teilentladungen verfälscht wird, welche durch die Schaltvorgänge verursacht sind. Die Qualität der Auswertung erhöht sich damit.

Optional ist weiter eine Adaptionseinrichtung vorgesehen. Zweckmäßigerweise ist sie als Einheit zur Störgrößenerfassung ausgeführt 74. Sie dient zur Erfassung der Umgebungsgeräusche und wirkt mit der Analyseeinheit 7 zusammen. Damit kann eine an die jeweiligen Umgebungsgeräusche angepasste Kalibrierung erreicht werden, sodass diese die Verarbeitung und Auswertung der gemessenen akustischen Signale nicht beeinträchtigen. Es kann aber auch auftreten, dass durch Umgebungseinflüsse die Messung durch die akustischen Sensoren 40 selbst verfälscht ist. Beispiel hierfür sind Auswirkungen von schweren Regentropfen bei im Freien angeordneten Transformatoren. Die auftreffenden Tropfen erzeugen eine akustische Signatur, die mitunter ähnlich zu derjenigen der Teilentladungen sein kann. Um insoweit eine Fehlzuordnung zu vermeiden, wird mittels eines geeigneten Umgebungsgeräusch-Sensors 44 das Vorhandensein der Störgröße (in dem vorliegenden Beispiel: schwerer Regen) erkannt und über die Störgrößenerfassung 74 der Adaptionseinrichtung in die Signalverarbeitung der von den akustischen Sensoren 40 gemessenen Signale entsprechend eingegriffen, um den Einfluss der Störgröße "durch schwere Regentropfen hervorgerufene akustische Emissionen" so auszugleichen. Im einfachsten Fall kann dies ein Ignorieren der von den A-Sensoren 40 erfassten Signale während der Störung durch den schweren Regen bedeuten. Besser sind fortgeschrittene Signalverarbeitungsverfahren, beispielsweise durch Anwendung von Faltungsoperationen durch sog. Optimalfilter. Auf diese Weise werden die Robustheit der Messungen und die Güte der Auswertung beträchtlich gesteigert.

Ferner ist zweckmäßigerweise eine Schadenbestimmungseinheit 8 vorgesehen, welche aus dem so ermittelten Signal einen Indikator für einen Schädigungsgrad bestimmt. Dieser gibt Aufschluss über den Umfang der erfassten Teilentladungen unter Berücksichtigung der Betriebsdauer des Transformators 2. Dazu weist die Schadenbestimmungseinheit 8 zweckmäßigerweise einen Langzeitspeicher 81 auf. Ferner weist sie vorzugsweise ein Modul 82 zur Bestimmung einer erwarteten Restlebensdauer auf. Auf diese Weise kann ermittelt werden, ob der Transformator 2 noch eine ausreichend hohe Restlebensdauer bis zu einem späteren geplanten Wartungszyklus hat, oder ob er möglichst bald, vorzugsweise bei der nächsten Wartung, auszutauschen ist. Das entsprechende Signal kann über ein Interface 83 an die Betriebssteuerung 15 oder an eine andere, gegebenenfalls entfernt angeordnete Stelle (beispielsweise den Betreiber eines Windparks, dem die Windenergieanlage 1 zugeordnet ist) übermittelt werden.

Bei einer besonders zweckmäßigen Ausführungsform, die gegebenenfalls auch unabhängigen Schutz verdient, können optional zusätzlich auch elektrische und/oder elektromagnetische Sensoren vorgesehen sein. Beispielsweise können elektrische Sensoren (E-Sensoren) vorgesehen sein, die ausgeführt sind als an der Anschlussleitung 17 angeordnete Impedanzen 18, welche als Messwiderstände zur Gewinnung elektrischer Signale im Transformator 2 fungieren. Die Messwiderstände 18 fungieren somit als E-Sensoren 61 zur Erfassung elektrischer Signale einer Teilentladung im Transformator 2. Ein weiterer Sensor 61` zur Erfassung elektromagnetischer Signale der Teilentladungen kann unmittelbar in dem Transformator 2 vorgesehen sein. Sie sind über Signalleitungen 63, 63` mit einer Korrelationseinheit 6 des Zustandsüberwachungssystems 3 verbunden. Diese ist ausgebildet für eine Korrelation zwischen elektrischen und akustischen Signalen, und kann dank dieser Korrelation auch solche (stummen) Teilentladungen berücksichtigen, die von den A-Sensoren 40 nicht erfasst wurden. Die Korrelationseinheit 6 kann ferner dazu ausgebildet sein, ein Stärkeverhältnis der von den A-Sensoren 40 und den E-Sensoren 61 ermittelten Signale zu bilden und/oder ein Häufigkeitsverhältnis. Auf diese Weise können weitere Informationen über Teilentladungen gewonnen werden, auch solche im Öl von Transformatoren, und es können in größerem Umfang abnorme Veränderungen erkannt werden, auf deren Grundlage dann das Warnsignal 77 ausgegeben wird.

## Patentansprüche

1. Zustandsüberwachungssystem für elektrische Leistungskomponenten, insbesondere einen Transformator (2), umfassend eine Teilentladung-Detektoreinheit, die ausgebildet ist zur Erfassung von Teilentladungen, mit mindestens einem A-Sensor , d.h. akustischer Sensor (40) zur Erfassung akustischer Signale der Teilentladung; und eine Verarbeitungseinheit (5) zur Verarbeitung der von dem A-Sensor (40) detektierten Signale,
**dadurch gekennzeichnet, dass**
die Verarbeitungseinheit (5) eine Häufigkeit-Bestimmungseinrichtung (51), welche eine Häufigkeit der von dem A-Sensor (40) detektierten Teilentladungen erfasst und ein Häufigkeitssignal ausgibt, sowie
ein Histogramm-Modul (52) umfasst, das dazu ausgebildet ist, aus dem Häufigkeitssignal und einem Zeitsignal einen Zeitverlauf der Häufigkeit zu bestimmen, und dass
eine Analyseeinheit (7) vorhanden ist, die dazu ausgebildet ist, den Zeitverlauf auf Ab- und/oder Anstieg zu überwachen und bei Überschreitung einer einstellbaren Schwelle ein Warnsignal (77) auszulösen.

2. Zustandsüberwachungssystem nach Anspruch 1, **dadurch gekennzeichnet, dass** die Analyseeinheit (7) ein Mustererkennungsmodul (73) aufweist, das mindestens ein Referenzmuster umfasst und dazu ausgebildet ist, eine Übereinstimmung des Zeitverlaufs mit dem Referenzmuster zu bewerten.

3. Zustandsüberwachungssystem nach Anspruch 2, **dadurch gekennzeichnet, dass** das Referenzmuster mehrphasig ist, und vorzugsweise eine Anfangsphase, Hauptphase und Endphase umfasst.

4. Zustandsüberwachungssystem nach einem der Ansprüche 2 bis 3, **dadurch gekennzeichnet, dass** das Referenzmuster automatisch *parametriert* ist, vorzugsweise mittels einer automatischen Verstärkungsregelung (75), weiter vorzugsweise bei mehrphasigem Referenzmuster für jede Phase individuell.

5. Zustandsüberwachungssystem nach einem der vorangehenden Ansprüche, **dadurch gekennzeichnet, dass** eine Adaptionseinrichtung (76) vorgesehen ist, die zu einer Kalibrierung der Analyseeinheit auf Umgebungsgeräusche ausgebildet ist, und die vorzugsweise einen Minimumdetektor umfasst.

6. Zustandsüberwachungssystem nach einem der vorangehenden Ansprüche, **dadurch gekennzeichnet, dass** die Analyseeinheit (7) eine Einrichtung zur Störgrößenerfassung (74) aufweist, an die vorzugsweise ein Umgebungsgeräusch-Sensor (44) angeschlossen ist.

7. Zustandsüberwachungssystem nach einem der vorangehenden Ansprüche, **dadurch gekennzeichnet, dass** die Analyseeinheit (7) weiter dazu ausgebildet ist, eine Anstiegssteilheit der Häufigkeit zu berechnen und abhängig davon das Warnsignal (77) auszulösen.

8. Zustandsüberwachungssystem nach einem der vorangehenden Ansprüche, **dadurch gekennzeichnet, dass** die Schwelle einen statischen und/oder dynamischen Schwellenwert (71, 72) umfasst.

9. Zustandsüberwachungssystem nach einem der vorangehenden Ansprüche, **dadurch gekennzeichnet, dass** ferner eine Einschaltsperre vorgesehen ist, die mit der Verarbeitungseinheit (5) und/oder der Analyseeinheit (7) derart zusammenwirkt, dass beim Wiedereinschalten das Überwachen der Teilentladungen gesperrt ist.

10. Zustandsüberwachungssystem nach einem der vorangehenden Ansprüche, **dadurch gekennzeichnet, dass** räumlich verteilt an der Leistungskomponente mehrere A-Sensoren (40, 40', 40", 40"`) angeordnet sind, wobei mindestens einer der A-Sensoren (40, 40`, 40", 40"`) unmittelbar an der elektrischen Leistungskomponente angeordnet ist.

11. Zustandsüberwachungssystem nach einem der vorangehenden Ansprüche, **dadurch gekennzeichnet, dass** zur Verarbeitung der A-Sensor-Signale ferner eine Lokalisator-Einheit (55) vorgesehen ist, die dazu ausgebildet ist, eine Ortsinformation über die Teilentladung zu bestimmen, wobei insbesondere die Lokalisator-Einheit weiter dazu ausgebildet ist, Ortsabweichungen der Teilentladungen zu detektieren, wobei vorzugsweise Teilentladungen an unterschiedlichen Orten gesondert erfasst sind.

12. Zustandsüberwachungssystem nach Anspruch 11, **dadurch gekennzeichnet, dass** die Lokalisator-Einheit weiter dazu ausgebildet ist, eine Ortsinformation über die Teilentladung zu bestimmen durch Verknüpfen der Signale von mehreren räumlich verteilt an der Leistungskomponente angeordneten A-Sensoren (40, 40 `, 40", 40"').

13. Zustandsüberwachungssystem nach einem der vorangehenden Ansprüche, **dadurch gekennzeichnet, dass** eine Schadenbestimmungseinheit (8) zur Bestimmung eines Indikators für einen Schädigungsgrad der Leistungskomponente vorgesehen ist, der vorzugsweise Intensität und Ort der detektierten Teilentladungen bewertet, und weiter vorzugsweise ortsgleiche Teilentladungen höher gewichtet.

14. Verfahren zur Zustandsüberwachung von elektrischen Leistungskomponenten, insbesondere eines Transformators, zum Detektieren von Teilentladungen, mit den Schritten:
Erfassen akustischer Signale mit mindestens einem A-Sensor, d.h. akustischen Sensor (40) und Bestimmen einer Häufigkeit der detektierten Teilentladungen;
Generieren eines Häufigkeitssignals daraus;
Generieren eines Zeitverlaufs der Häufigkeit basierend auf dem Häufigkeitssignal und einem Zeitsignal; und
Analysieren des Zeitverlaufs der Häufigkeit unter Prüfung auf Abstieg und/oder Anstieg und, ob eine einstellbare Schwelle überschritten wird und Auslösen eines Warnsignals bei Überschreitung der Schwelle.

15. Verfahren nach Anspruch 14, **dadurch gekennzeichnet, dass** ein Zustandsüberwachungssystem nach einem der Ansprüche 2 bis 13 verwendet wird.

## Claims

1. Condition monitoring system for electrical power components, in particular a transformer (2), comprising a partial discharge detector unit, which is designed to detect partial discharges, comprising at least one A sensor, i.e. acoustic sensor, (40) for detecting acoustic signals of the partial discharge; and
a processing unit (5) for processing the signals detected by the A sensor (40),
**characterized in that**
the processing unit (5) comprises an incidence rate determination device (51), which detects an incidence rate of the partial discharges detected by the A sensor (40) and outputs an incidence rate signal, and
a histogram module (52), which is designed to determine a time characteristic of the incidence rate from the incidence rate signal and a time signal, and **in that** an analysis unit (7) is present, which is designed to monitor the time characteristic for fall and/or rise and to trigger a warning signal (77) when a settable threshold is exceeded.

2. Condition monitoring system according to Claim 1, **characterized in that** the analysis unit (7) has a pattern recognition module (73), which comprises at least one reference pattern and is designed to assess whether the time characteristic matches the reference pattern.

3. Condition monitoring system according to Claim 2, **characterized in that** the reference pattern is polyphasic and preferably comprises a start phase, a main phase and an end phase.

4. Condition monitoring system according to either of Claims 2 and 3, **characterized in that** the reference pattern is automatically *parameterized,* preferably by means of automatic amplification control (75), additionally preferably, in the case of a polyphasic reference pattern, individually for each phase.

5. Condition monitoring system according to one of the preceding claims, **characterized in that** there is provision for an adaptation device (76), which is designed to calibrate the analysis unit in respect of environmental noise, and which preferably comprises a minimum detector.

6. Condition monitoring system according to one of the preceding claims, **characterized in that** the analysis unit (7) has a device for disturbance variable detection (74), to which an environmental noise sensor (44) is preferably connected.

7. Condition monitoring system according to one of the preceding claims, **characterized in that** the analysis unit (7) is additionally designed to calculate a rate of rise of the incidence rate and, depending thereon, to trigger the warning signal (77).

8. Condition monitoring system according to one of the preceding claims, **characterized in that** the threshold comprises a static and/or dynamic threshold value (71, 72).

9. Condition monitoring system according to one of the preceding claims, **characterized in that** there is additionally provision for a switch-on lockout, which interacts with the processing unit (5) and/or the analysis unit (7) in such a way that, during restarting, the monitoring of the partial discharges is disabled.

10. Condition monitoring system according to one of the preceding claims, **characterized in that** a plurality of A sensors (40, 40', 40", 40‴) are arranged in a spatially distributed manner on the power component, at least one of the A sensors (40, 40', 40", 40‴) being arranged directly on the electrical power component.

11. Condition monitoring system according to one of the preceding claims, **characterized in that**, for processing the A sensor signals, there is additionally provision for a locator unit (55), which is designed to determine location information relating to the partial discharge, the locator unit in particular additionally being designed to detect locational discrepancies of the partial discharges, partial discharges at different locations preferably being detected separately.

12. Condition monitoring system according to Claim 11, **characterized in that** the locator unit is additionally designed to determine location information relating to the partial discharge by combining the signals from a plurality of A sensors (40, 40', 40", 40‴) arranged in a spatially distributed manner on the power component.

13. Condition monitoring system according to one of the preceding claims, **characterized in that** there is provision for a damage determination unit (8) for determining an indicator of a degree of damage to the power component, which degree of damage preferably assesses the intensity and location of the detected partial discharges, and additionally preferably applies a higher weighting to partial discharges with the same location.

14. Method for monitoring the condition of electrical power components, in particular a transformer, for detecting partial discharges, comprising the steps of:
detecting acoustic signals using at least one A sensor, i.e. acoustic sensor, (40) and determining an incidence rate of the detected partial discharges;
generating an incidence rate signal therefrom;
generating a time characteristic of the incidence rate on the basis of the incidence rate signal and a time signal;
and
analysing the time characteristic of the incidence rate whilst checking for fall and/or rise and whether a settable threshold is being exceeded, and triggering a warning signal when the threshold is exceeded.

15. Method according to Claim 14, **characterized in that** a condition monitoring system according to one of Claims 2 to 13 is used.

## Revendications

1. Système de surveillance de l'état de composants électriques de puissance, en particulier d'un transformateur (2), comprenant une unité de détection de décharges partielles, qui est configurée pour détecter des décharges partielles, dotée d'au moins un capteur A, c'est-à-dire d'un capteur acoustique (40) destiné à détecter des signaux acoustiques de la décharge partielle; et
une unité de traitement (5) destinée à traiter les signaux détectés par le capteur A (40),
**caractérisé en ce que** l'unité de traitement (5) comprend un dispositif de détermination de fréquence (51) qui détecte une fréquence des décharges partielles détectées par le capteur A (40) et délivre un signal de fréquence, et
un module d'histogramme (52) qui est configuré pour déterminer une évolution temporelle de la fréquence à partir du signal de fréquence et d'un signal temporel, et **en ce qu'**il est prévu
une unité d'analyse (7) qui est configurée pour surveiller l'évolution temporelle de la diminution et/ou de l'augmentation et pour déclencher un signal d'avertissement (77) en cas de dépassement d'un seuil réglable.

2. Système de surveillance d'état selon la revendication 1, **caractérisé en ce que** l'unité d'analyse (7) comporte un module de reconnaissance de motif (73) qui comprend au moins un motif de référence et est configuré pour évaluer une correspondance entre l'évolution temporelle et le motif de référence.

3. Système de surveillance d'état selon la revendication 2, **caractérisé en ce que** le motif de référence est polyphasé, et comprend de préférence une phase initiale, une phase principale et une phase finale.

4. Système de surveillance d'état selon l'une des revendications 2 à 3, **caractérisé en ce que** le motif de référence est paramétré automatiquement, de préférence au moyen d'une commande automatique de gain (75), et plus préférablement dans le cas d'un motif de référence polyphasé individuellement pour chaque phase.

5. Système de surveillance d'état selon l'une des revendications précédentes, **caractérisé en ce qu'**il est prévu un dispositif d'adaptation (76) qui est configuré pour effectuer un étalonnage de l'unité d'analyse vis-à-vis de bruits ambiants, et qui comprend de préférence un détecteur de minimum.

6. Système de surveillance d'état selon l'une des revendications précédentes, **caractérisé en ce que** l'unité d'analyse (7) comporte un dispositif de détection de grandeurs perturbatrices (74) auquel est de préférence raccordé un capteur de bruit ambiant (44).

7. Système de surveillance d'état selon l'une des revendications précédentes, **caractérisé en ce que** l'unité d'analyse (7) est en outre configurée pour calculer une pente d'augmentation de la fréquence et, en fonction de celle-ci, pour déclencher le signal d'avertissement (77).

8. Système de surveillance d'état selon l'une des revendications précédentes, **caractérisé en ce que** le seuil comprend une valeur de seuil statique et/ou dynamique (71, 72).

9. Système de surveillance d'état selon l'une des revendications précédentes, **caractérisé en ce qu'**il est en outre prévu un blocage de l'activation qui coopère avec l'unité de traitement (5) et/ou l'unité d'analyse (7) de telle manière que, lors de la réactivation, la surveillance des décharges partielles est bloquée.

10. Système de surveillance d'état selon l'une des revendications précédentes, **caractérisé en ce que** plusieurs capteurs A (40, 40', 40", 40"') sont disposés de manière spatialement répartie sur le composant de puissance, au moins l'un des capteurs A (40, 40', 40", 40"') étant disposé directement sur le composant de puissance électrique.

11. Système de surveillance d'état selon l'une des revendications précédentes, **caractérisé en ce qu'**il est en outre prévu, pour le traitement des signaux des capteurs A, une unité de localisation (55) qui est configurée pour déterminer une information de position concernant la décharge partielle, l'unité de localisation étant notamment configurée en outre pour détecter des écarts de position des décharges partielles, les décharges partielles étant préférablement détectées séparément à différentes positions.

12. Système de surveillance d'état selon la revendication 11, **caractérisé en ce que** l'unité de localisation est en outre configurée pour déterminer une information de position concernant la décharge partielle en combinant les signaux de plusieurs capteurs A (40, 40', 40", 40"') disposés de manière spatialement répartie sur le composant de puissance.

13. Système de surveillance d'état selon l'une des revendications précédentes, **caractérisé en ce qu'**il est prévu une unité de détermination d'endommagement (8) destinée à déterminer un indicateur d'un degré d'endommagement du composant de puissance, qui évalue de préférnce l'intensité et la position des décharges partielles détectées, et qui pondère en outre de préférence plus fortement les décharges partielles de même position.

14. Procédé de surveillance de l'état de composants électriques de puissance, en particulier d'un transformateur, pour détecter des décharges partielles, comprenant les étapes suivantes :
la détection de signaux acoustiques au moyen d'au moins un capteur A, c'est-à-dire d'un capteur acoustique (40) et la détermination d'une fréquence des décharges partielles détectées;
la génération d'un signal de fréquence à partir de celui-ci;
la génération d'une évolution temporelle de la fréquence sur la base du signal de fréquence et d'un signal temporel;
et
l'analyse de l'évolution temporelle de la fréquence en vérifiant si celle-ci diminue et/ou augmente et si un seuil réglable est dépassé et en déclenchant un signal d'avertissement en cas de dépassement du seuil.

15. Procédé selon la revendication 14, **caractérisé en ce qu'**un système de surveillance d'état selon l'une des revendications 2 à 13 est utilisé.
